**Europäisches Patentamt**

**European Patent Office**

**Office européen des brevets**

(19)

(11) Veröffentlichungsnummer: **0 153 901 B1**

(12) # EUROPÄISCHE PATENTSCHRIFT

(45) Veröffentlichungstag der Patentschrift: **29.05.91**

(51) Int. Cl.⁵: **G01N 22/00**

(21) Anmeldenummer: **85730008.1**

(22) Anmeldetag: **24.01.85**

(54) **Verfahren zur Herstellung von halbleitenden Materialien und/oder Halbleiter-Bauelementen.**

(30) Priorität: **25.01.84 DE 3402822**

(43) Veröffentlichungstag der Anmeldung:
**04.09.85 Patentblatt 85/36**

(45) Bekanntmachung des Hinweises auf die
Patenterteilung:
**29.05.91 Patentblatt 91/22**

(84) Benannte Vertragsstaaten:
**AT BE CH DE FR GB IT LI LU NL SE**

(56) Entgegenhaltungen:
**US-A- 3 939 415**
**US-A- 4 332 833**

**IEEE TRANSACTIONS ON INSTRUMENTA-
TION AND MEASUREMENT, Band IM-32, Nr. 2,
Juni 1983, Seiten 326-331, New York, US; I.
SHIH et al.: "A technique for photoelectric
and photodielectric effect measurements at
microwave frequencies"**

**REVIEW OF SCIENTIFIC INSTRUMENTS, Band
55, Nr. 8, August 1984, Seiten 1343-1347, New
York, US; R.J. DERI et al.: "Microwave photoconductivity lifetime measurements: Experimental limitations"**

(73) Patentinhaber: **Hahn-Meitner-Institut Berlin
Gesellschaft mit beschränkter Haftung
Glienicker Str. 100
W-1000 Berlin 39(DE)**

(72) Erfinder: **Tributsch, Helmut, Prof.-Dr.
Alsenstrasse 24
W-1000 Berlin 39(DE)**
Erfinder: **Beck, Gerhard, Dr.-Ing.
Beskidenstrasse 54
W-1000 Berlin 38(DE)**
Erfinder: **Kunst, Marinus, Dr.
Carmerstrasse 16
W-1000 Berlin 12(DE)**
Erfinder: **Küppers, Udo, Dr.-Ing.
Potsdamer Chaussee 49
W-1000 Berlin 38(DE)**
Erfinder: **Lewerenz, Hans-Joachim, Dr.rer.nat.
Pacelliallee 15 a
W-1000 Berlin 33(DE)**
Erfinder: **Werner, André, Dipl.-Phys.
Beerenstrasse 24
W-1000 Berlin 37(DE)**
Erfinder: **Lilie, Jochen, Dr. rer.nat.
Terrassenstrasse 21 b
W-1000 Berlin 38(DE)**

JOURNAL OF THE ELECTROCHEMICAL SO-CIETY, Band 131, Nr. 4, April 1984, Seiten 954-956, Princeton, New York, US; M. KUNST et al.: "Time-resolved microwave cnductivity (TRMC): photoeffects at semiconductor/electrolyte interfaces"

PATENT ABSTRACTS OF JAPAN, Band 7, Nr. 222 (E-201)[1367], 4. Oktober 1983; & JP - A - 58 112 332 (FUJITSU) 04.07.1983

(74) Vertreter: **Wolff, Konrad**
**Heinrich-Hertz-Institut für Nachrichtentech-nik Berlin GmbH Einsteinufer 37**
**W-1000 Berlin 10(DE)**

**Beschreibung**

Die Erfindung bezieht sich auf ein Verfahren zur Herstellung von halbleitenden Materialien und/oder Halbleiter-Bauelementen, bei dem unter Verwendung einer Regelschleife, in der Meß- und Stellglieder über einen Rechner gekoppelt sind, in-situ eine Materialeigenschaft untersucht wird und aufgrund der Untersuchungsergebnisse die Parameter des Herstellungsprozesses eingestellt werden.

Dabei wird von einem Stand der Technik ausgegangen, wie er aus der US-A-4 332 833 entnommen werden kann. Die dort beschriebene Methode zur optischen Untersuchung bei der Herstellung von Halbleiterschichten ermöglicht sowohl nach als auch schon während der Ausbildung von Materialschichten aus der z.B. durch Ellipsometrie prüfbaren morphologischen Perfektion der Schichtoberfläche Rückschlüsse auf die Dielektrizitätsfunktion in Dielektrika, dotierten oder undotierten Halbleitern oder Metallen zu ziehen und derartige Informationen z.B. dazu zu verwenden, eine entsprechende Steuerreaktion eines Parameters beim Herstellungsprozeß auszulösen.

Bei den Bestrebungen zur Automatisierung von Prozeßabläufen bestehen die wesentlichen Probleme darin, einen Effekt ausfindig zu machen, der für Eigenschaften des hergestellten Zwischenprodukts oder fertigen Erzeugnisses besonders charakteristisch ist, zu dessen Bestimmung die anzuwendenden Meßmethoden verläßlich, schnell, zerstörungsfrei sowie kompatibel mit den Bedingungen des zu automatisierenden Herstellungsverfahrens sind. Insbesondere müssen sich die Zusammenhänge zwischen Änderungen der Meßwerte und den Prozeßparametern richtig deuten lassen, damit die zutreffenden Schlußfolgerungen gezogen werden können. Schließlich ist dann ein Rechnersystem entsprechend zu programmieren.

Materialien mit gleichen oder ähnlichen dielektrischen Eigenschaften können äußerst unterschiedliche elektrooptische Eigenschaften aufweisen. Die oben erwähnte optische Untersuchung gewährleistet also für photoaktive Materialien keine eindeutige Korrelierbarkeit.

In IEEE Transactions on Instrumentation and Measurement, Band IM-32, Nr. 2, Juni 1983, Seiten 326 - 331, New York, US; I. Shih et al: "A technique for photoelectric and photodielectric effect measurement at microwave frequencies" ist beschrieben, eine Materialprobe mit im wesentlichen photoaktiven Eigenschaften zur Anregung von Ladungsträgern zu bestrahlen und Änderungen eines von der Probe beeinflußten Mikrowellenfeldes zu messen und auszuwerten. Dazu ist eine Mikrowellen-Brückenschaltung vorzusehen und die zu untersuchende Materialprobe in eine Mikrowellenleitung mit Fenstern für externe Bestrahlung einzubringen. Es lassen sich Phase und Dämpfung zunächst ohne und sodann mit in der Probe angeregten Ladungsträgern bestimmen. Eine solche Methode ist für eine in-situ Automatisierung eines Herstellungsprozesses nicht geeignet, weil die Messung und Auswertung zu viel Zeit beansprucht und auch nicht zerstörungsfrei durchgeführt werden kann.

Eine Methode, die ebenfalls externe Bestrahlung und Mikrowellen anwendet und auch schnell und im wesentlichen zerstörungsfrei durchgeführt werden kann, ist für die Bestimmung der Ladungsträgerlebensdauer in Halbleitern aus US-A - 3 939 415 bekannt. Dabei wird ein Ausschnitt der bestrahlten Fläche mit einer Mikrowellenantenne abgetastet und der Meßwert als repräsentativ, zumindest für angrenzende Bereiche angesehen. Inwieweit die Verläßlichkeit gewährleistet bleibt, wenn die beiden Maßnahmen zum Herbeiführen und zum Detektieren der Ladungsträgerkonzentration jeweils den gesamten Bereich erfassen sollen und sich dann möglicherweise gegenseitig behindern bzw. ausschließen, ist in diesem Zusammenhang nicht erwähnt oder angedeutet.

Das der Erfindung zugrundeliegende technische Problem besteht somit darin, Maßnahmen für die automatisierte Herstellung photoaktiver Materialien und Systeme aufzuzeigen, die auf verläßliche, schnelle und zerstörungsfreie Weise sowie im wesentlichen kontaktfrei und kompatibel mit den Prozeßbedingungen bei der Herstellung eine in-situ Untersuchung einer besonders charakteristischen Materialeigenschaft und eine Änderung von Prozeßparametern in Echtzeit gewährleistet. Dadurch soll eine Optimierung - auch in dem Sinne, daß eine Verbesserung der Ausbeute bei noch zulässiger Qualitätseinbuße und/oder zweckmäßig geänderter Prozeßdauer herbeizuführen ist - sowohl für herkömmliche als auch für neuartige photosensible Materialien und Systeme ermöglicht werden.

Bei der Lehre zum technischen Handeln ist bei der erfindungsgemäßen Lösung vorgesehen, daß für Materialien und/oder Bauelemente, die im wesentlichen photoaktive Eigenschaften aufweisen, eine Optimierung der Herstellung bezüglich Qualität, Ausbeute und Prozeßdauer herbeigeführt wird, indem:

a) Schichten des Materials/Bauelements kontinuierlich, unter änderbaren Prozeßbedingungen ausgebildet werden;

b) das Material/Bauelement während der Ausbildung von Schichten zum Detektieren der zu untersuchenden Materialeigenschaft einem elektromagnetischen Feld ausgesetzt wird;

c) als zu untersuchende Materialeigenschaft die Photoleitfähigkeit verwendet wird, die durch Bestrahlen der sich ausbildenden Schichten infolge Anregung von Ladungsträgern herbeigeführt wird;

d) Änderungen der Photoleitfähigkeit durch wiederholtes Bestrahlen hervorgerufen, detektiert und als Meßwerte erfaßt werden;

e) erfaßte Meßwerte dem Rechner zugeführt und dort hinsichtlich des aktuell erreichbaren Optimums ausgewertet werden;

f) Steuersignale für Stellglieder, mit denen die Prozeßbedingungen vorgegeben werden, vom Rechner bereitgestellt werden;

g) die betreffenden Prozeßparameter den Steuersignalen entsprechend geändert werden;

h) die unter c) bis g) angegebenen Maßnahmen mehrmals durchgeführt werden, während die unter a) und b) angegebenen Maßnahmen so lange aufrechterhalten bleiben, bis die optimal auszubildende Schicht vollständig entwickelt ist.

Das Wesen der Erfindung und ihre Vorteile liegen dabei nicht nur darin, daß ohne Unterbrechungen des Herstellungsprozesses eine Qualitätskontrolle erfolgt und eventuell erforderliche Änderungen der Prozeßparameter sofort wirksam werden, sondern automatisch bei derartigen Änderungen der Prozeßparameter deren spezifische Auswirkungen jeweils zur gewünschten Gesamtwirkung optimal miteinander kombiniert werden. Zudem sind derartige Kombinationen nicht allein auf empirisch gewonnene Erkenntnisse beschränkt. Das Rechnersystem kann selbsttätig aufgrund seiner Lern- und Merkfähigkeit aus dem Spektrum der verfügbaren Parameterkombinationen das Optimum bestimmen und auswählen.

Von grundlegender Bedeutung für die erfindungsgemäße Lösung ist die Tatsache, daß es sich um photoaktive Materialien bzw. Bauelemente handelt, deren Photoleitfähigkeit ohne Beeinträchtigung der Bedingungen des Herstellungsprozesses gemessen werden kann. Dies kann vorteilhaft durch eine kontaktfreie Meßmethode erfolgen. Bekannte Mikrowellenmessungen, z.B. wie weiter oben abgehandelt und auch in jüngerer Zeit als ex-situ-Untersuchungsmethoden für unterschiedliche Halbleitersysteme von steigendem Interesse, sind für Ausführungsformen der Erfindung besonders gut geeignet. Die Photosensibilität wird - auch bei Messungen über elektrische, vor der Beschichtung am Substrat angebrachte Kontakte - durch kontaktfreie Anregung von Ladungsträgern z.B. in zeitaufgelösten Messungen geprüft. Unter bestimmten Voraussetzungen, z.B. bei kleiner Beweglichkeit der Ladungsträger, sind derartige Qualitätssignale, gemessen über die Mikrowellenabsorption (TRMC) oder direkt als Photoleitfähigkeit (PC), äquivalent. Welche Meßmethode angewendet wird, richtet sich nach den jeweiligen technischen Gegebenheiten.

Weitere Ausführungsformen der Erfindung sind in den Unteransprüchen 5 bis 10 gekennzeichnet. Diese betreffen in der Hauptsache die in-situ-Messungen und damit im Zusammenhang stehende Randbedingungen sowie Maßnahmen allgemeiner Art für die Prozeßführung, bei der in einzelnen Stufen durchaus unterschiedliche, sich gegenseitig womöglich ungünstig beeinflussende Bedingungen einzuhalten sind. Hierfür läßt sich dann beispielsweise auf Mehrkammersysteme zurückgreifen, in denen unterschiedliche Temperaturen, Drücke, Gaszusammensetzungen, längere oder kürzere Verweilzeiten, örtliche Fixierung des in der Herstellung befindlichen Produkts für bestimmte Dauer, Rotationsbewegungen und vieles mehr realisiert werden können. Der Übergang von einer solchen Prozeßstufe zur nächsten sollte dabei in kürzest möglicher Zeit stattfinden, insgesamt also ein kontinuierlicher Ablauf, infolge oben erwähnter Abweichungen genauer mit quasi-kontinuierlichem Transport zu bezeichnen, gewährleistet werden.

In der Zeichnung sind Einzelheiten der Erfindung und ihrer Ausführungsformen schematisch dargestellt. Dabei zeigen:

| | |
|---|---|
| Fig. 1: | eine Prinzipskizze für eine Anlage zur Ausführung des erfindungsgemäßen Herstellungsverfahrens; |
| Fig. 2: | ein Flußdiagramm eines Arbeitsschrittes im Rahmen einer Optimierungsstrategie; |
| Fig. 3: | eine Prinzipskizze für eine Anlage mit rechnergestützter Verfahrensoptimierung (CAPO-Anlage); |
| Fig. 4: | einen Querschnitt durch eine Reaktionskammer als Momentaufnahme eines Prozeßablaufs; |
| Fig. 5: | eine Prinzipskizze einer Plasmadepositionsanlage mit PC-Meßapparatur; |
| Fig. 6: | eine Prinzipskizze einer Plasmadepositionsanlage mit Mikrowellen-Meßapparatur; |
| Fig. 7: | ein Schaubild für die Äquivalenz von PC- und TRMC-Signalen (Photostrom über der Zeit bei konstanter Temperatur), |
| Fig. 8: | ein Schaubild für die Äquivalenz von PC- und TRMC-Signalen (Photostrom über der Temperatur), |
| Fig. 9: | ein Schaubild für eine dreistufige Intervalleinengung bei der Suche eines optimalen Parameters (Fibonacci-Suche); |
| Fig. 10, 11 und 12: | Schaubilder für die bei der Suche gemäß Fig. 9 gemessenen Photospannungen; |
| Fig. 13: | eine Prinzipskizze für eine Mikrowellenmeßanordnung eines photoaktiven elektrochemischen Systems; |

| Fig. 14: | ein Blockschaltbild einer Mikrowellenmeßanordnung; |
| Fig. 15: | ein Schaubild für den Verlauf des Photo- und des Dunkelstromes für das System gemäß Fig. 13; |
| Fig. 16: | ein Schaubild für den Verlauf der induzierten Mikrowellen-Leitfähigkeit in Abhängigkeit von der Zeit bei unterschiedlichem Elektrodenpotential für das System gemäß Fig. 13 |
| und Fig. 17: | ein Schaubild für den Vergleich des Zeitbedarfs bei verschiedenen Prozessen. |

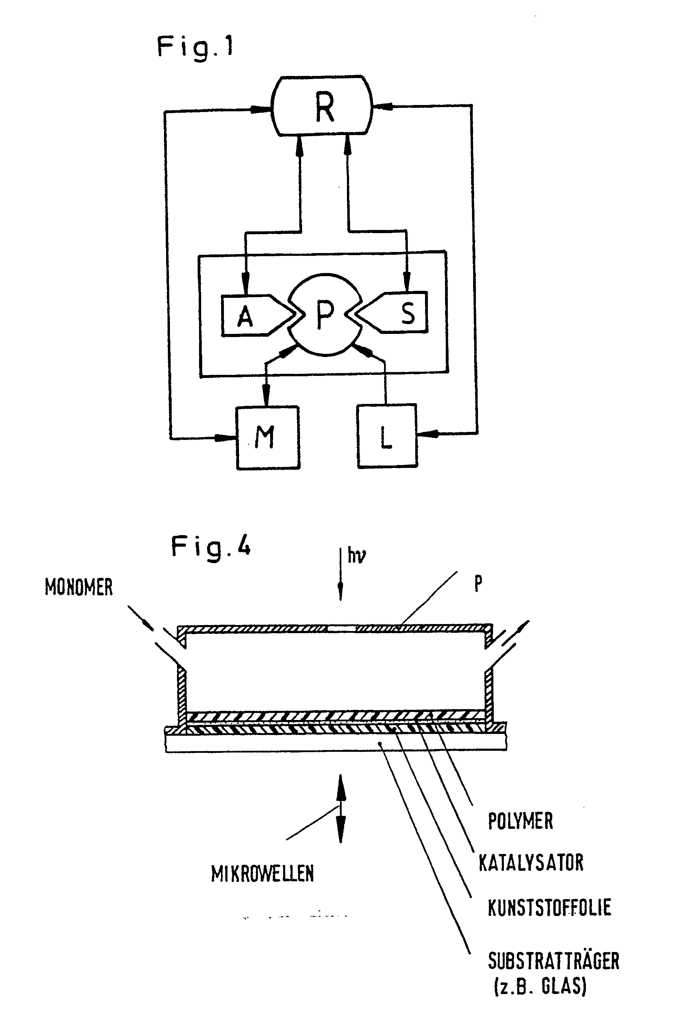

Eine Anlage zur Ausführung des erfindungsgemäßen Herstellungsverfahrens enthält die in Fig. 1 dargestellten Anlageteile, die miteinander über die eingezeichneten, mit entsprechenden Pfeilen versehenen Linien in Wirkverbindung stehen. Die Herstellung von photosensiblen Materialien oder Systemen, insbesondere Bauelementen, die auch in einem Prozeß zur Verbesserung vorhandenen Materials bestehen kann, erfolgt in einer Prozeßkammer P. Es können auch mehrere Prozeßkammern P vorgesehen sein. Die Eigenschaften des photosensiblen Materials oder Systems in der Prozeßkammer P werden als Qualitätssignale mittels einer Meßapparatur M bestimmt. Dazu wird das Material oder System in der Kammer P von außen bestrahlt, im dargestellten Beispiel von einer Lichtquelle L. Ein Rechner R empfängt sowohl von der Meßapparatur M als auch von Sensoren S Meßsignale, wertet diese aus, berechnet die Parameterwerte für den weiteren Prozeßablauf und regelt dementsprechend insbesondere Stellglieder oder Aktoren A. Damit bildet diese Anlage einen in sich geschlossenen, vollautomatisch arbeitenden Regelkreis.

Die Einstellungen der Aktoren A für einen optimalen Prozeßablauf werden fortlaufend aktualisiert. Insbesondere können bei der Herstellung von herkömmlichen oder neuartigen photosensiblen Materialien oder Systemen neue Kombinationen von Verfahrensparametern gefunden werden, die zu einer höheren Materialqualität führen.

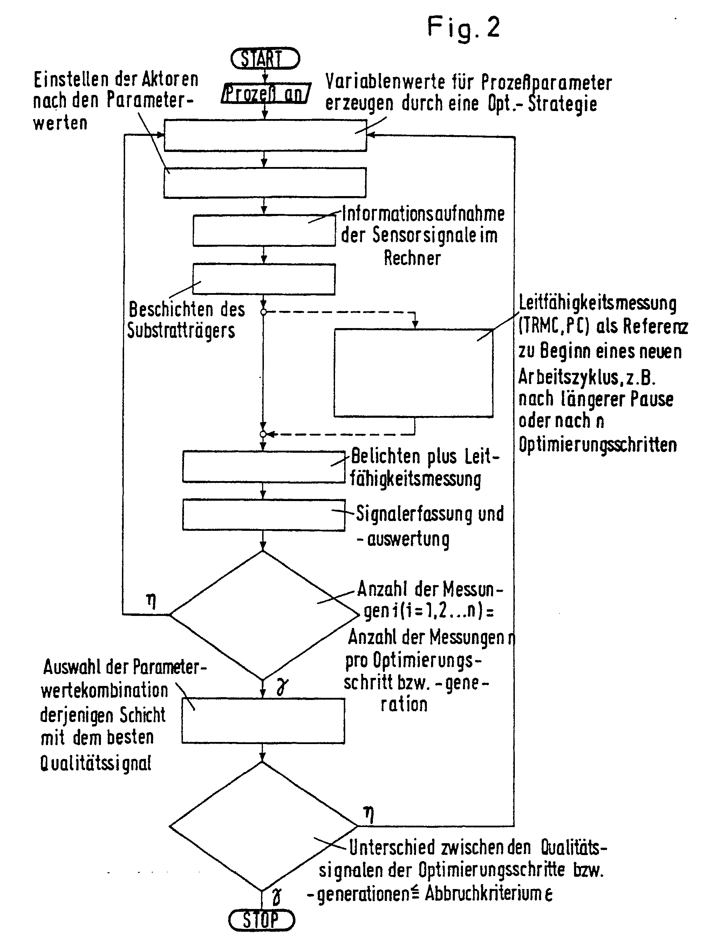

Der Ablauf eines Arbeitsschrittes im Rahmen einer Optimierungsstrategie ist detailliert in Fig. 2 angegeben.

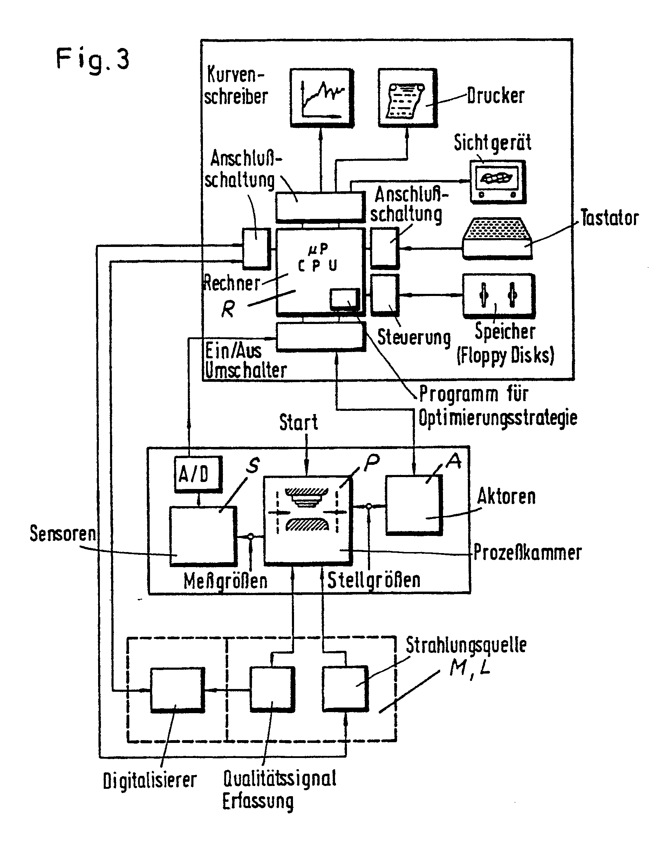

In Fig. 3 ist eine Versuchsanlage für die rechnergestützte Verfahrensoptimierung (computer aided process optimization - CAPO) dargestellt. Die einzelnen Anlagenteile sind mit den Bezugszeichen entsprechend Fig. 1 versehen, insbesondere beim Rechner R sind noch einzelne Peripheriegeräte dargestellt. Mit einer derartigen Anlage können insbesondere die Verfahrensbedingungen für die Herstellung neuartiger photosensibler Materialien ermittelt werden.

Die Wirkungsweise des erfindungsgemäßen Verfahrens wird nachfolgend anhand einiger Beispiele näher erläutert.

Beispiel 1: Herstellung amorpher Siliziumschichten für Solarzellen.

Amorphes Silizium, a-Si, kann in einer Glimmentladung durch Zersetzung von Silan, $SiH_4$, hergestellt werden. Verfahrensparameter dabei sind insbesondere: Druck in der Depositionskammer, Substrattemperatur, Durchflußgeschwindigkeit eines Gases oder Gasgemisches. Sowohl die Verstellung der Aktoren A, z.B. von Ventilen, Heizungsreglern, als auch die Sammlung und Auswertung von Qualitäts-undSensorsignalen, erfolgt vom bzw. im Rechner R. Dabei werden Richtung und Größe der Änderungen von Prozeßparametern festgelegt und nach Experimentierregeln von Optimierungsstrategien, z.B. Evolutionsstrategie, optimiert. Maßstab dafür ist die Änderung der induzierten Leitfähigkeit in der a-Si-Schicht. Diese wird z.B. durch Mikrowellenmessung ermittelt. Hierbei gilt die Proportionalität von $\Delta P$ - Änderung der Mikrowellenabsorption - und $\Delta\sigma$ - Änderung der Leitfähigkeit durch Anregung von Ladungsträgern -.

Beispiel 2: Herstellung einer photoleitenden Polymerschicht.

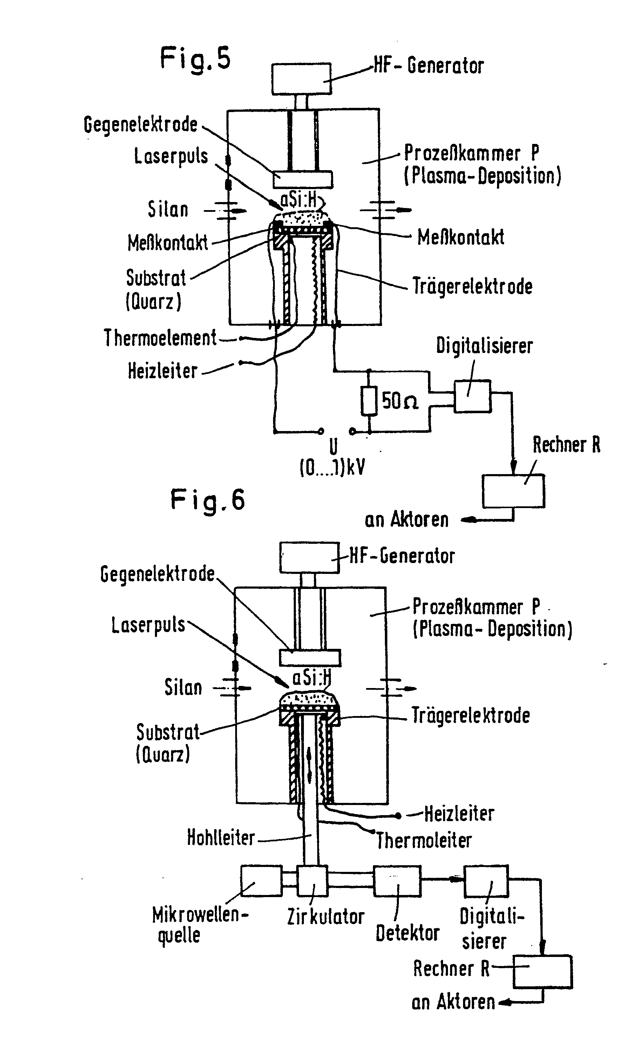

Für den Prozeß in einer Anlage gemäß Fig. 3 zeigt für dieses Beispiel die Fig. 4 einen Querschnitt durch die Reaktions- bzw. Prozeßkammer P als eine Momentaufnahme im Prozeßablauf. Hierbei wird eine kontaktierte Kunststoffolie, die auf einem Substratträger, z. B. aus Glas, befestigt ist, mit einem Katalysator, beispielsweise Ziegler-Natta-Katalysator, belegt. Durch die Kammer P strömt ein Monomer, z. B. Azetylen. Durch Reaktion mit dem Katalysator entsteht Polyazetylen, das sich als Polymerschicht ablagert.

Die Optimierung dieses Prozesses erfolgt auch hier durch Anregung von Ladungsträgern mittels Licht und durch Mikrowellenmessungen in der oben im Zusammenhang mit Beispiel 1 erläuterten Weise.

Beispiel 3: Vergütung einer Oberfläche.

Ein photoempfindliches Substrat soll mit einer Schicht zur Oberflächenvergütung versehen werden und dabei vorgegebene Qualitätsanforderungen erfüllen. Die Zusammensetzungund die Dicke dieser Schicht wird in einer Anlage gemäß Fig. 3 den vorgegebenen Anforderungen entsprechend optimal hergestellt. Es entsteht z. B. eine Antireflexionsschicht, eine passivierende Schicht für ein optoelektronisches Bauteil, eine Antikorrosionsschicht usw.

Beispiel 4: Elektrochemische Abscheidung einer Schicht.

Die Prozeßkammer P ist als elektrochemische Zelle ausgebildet. Schichten werden entsprechend der Einstellung der Prozeßparameter abgeschieden und bilden sich dabei hinsichtlich der vorgegebenen Anforderungen optimal aus.

Beispiel 5: Herstellung energieumwandelnder Grenzschichten, z. B. für eine p-n-Solarzelle.

In einer Prozeßkammer P wird auf einer p-leitenden Schicht eine n-leitende abgeschieden. Gemessen wird die zeitliche Änderung der Mikrowellenabsorption. Maßstab für die Optimierung ist auch hier die induzierte Leitfähigkeit infolge der durch Bestrahlung von außen in den hergestellten Schichten angeregten Ladungsträger, d. h. die Änderung der Leitfähigkeit.

Die in den Fig. 5 und 6 dargestellten Plasmadepositionsanlagen sind im wesentlichen identisch. Sie unterscheiden sich durch die Meßapparaturen, die dort angeschlossen sind. Bei der Anlage gemäß Fig. 5 wird die Photoleitfähigkeit direkt über Kontakte gemessen, die vor der Beschichtung am Substrat anzubringen sind. Die Anlage gemäß Fig. 6 ist hingegen mit einer Mikrowellen-Meßapparatur ausgerüstet.

Mit einer solchen Anlage, die mit den nachfolgend angegebenen Geräten aufgebaut war:

- Rechner:           Mikro PDP 11, Fa. DEC
- Terminal:          Fa. DEC
- Prozeßkammer     - Vakuumsystem: Balzers TSU 171
                       - Pumpen: Leybold TM 230
                       - Drucksensoren: PM 410
                       - HF-Komponenten: Kenwood TS 530 S,AT 230
                       - Durchflußmesser: MKS 260, 264 A, 260 PS-2
                       - Temperaturregler: Eurotherm Typ 820
                       - Energieversorgung: SM 6020 ($\delta$-Elektronik)
- Strahlungsquelle:   Nd-YAG-Laser, Pulsdauer 10 ns, Wellenlängen: 1064 nm und 532 nm
- Meßapparatur:      Mikrowellenbauteile der Firmen Hughes, USA;Mid-Century, GB; Waveline, USA
- Digitalisierer:       AD 7912, Tektronix

wurde eine eindimensionale in-situ-Optimierung nach der Fibonacci-Suche mit der Temperatur als Variable durchgeführt.

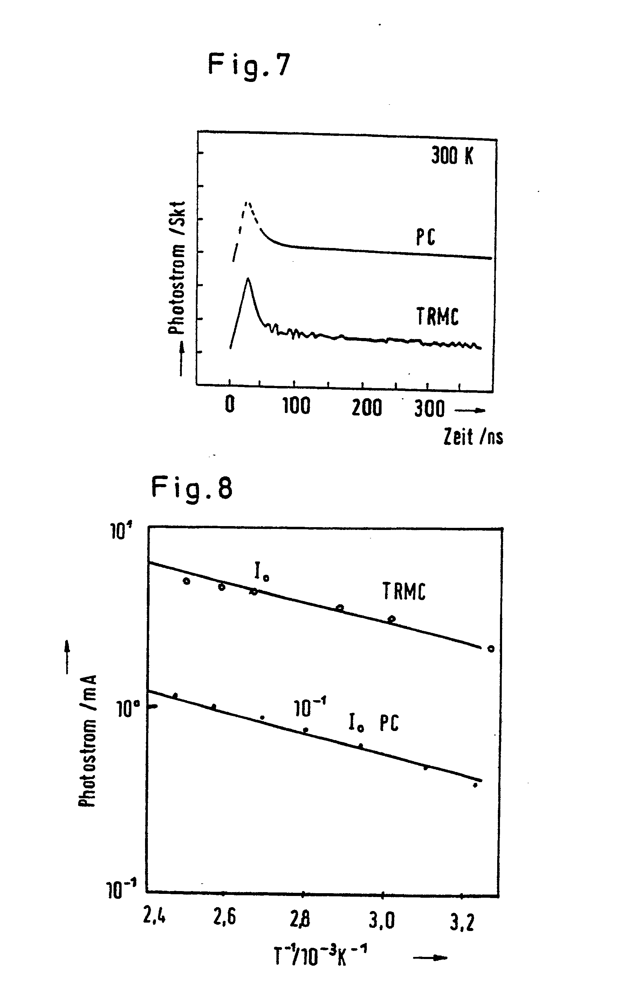

Die mit der Mikrowellenmeßapparatur erhaltenen Qualitätssignale sind denen der Photoleitfähigkeitsmessung gemäß Fig. 5 unter bestimmten Bedingungen, insbesondere bei kleiner Ladungsträgerbeweglichkeit, äquivalent, wie aus den Fig. 7 und 8 zu erkennen ist.

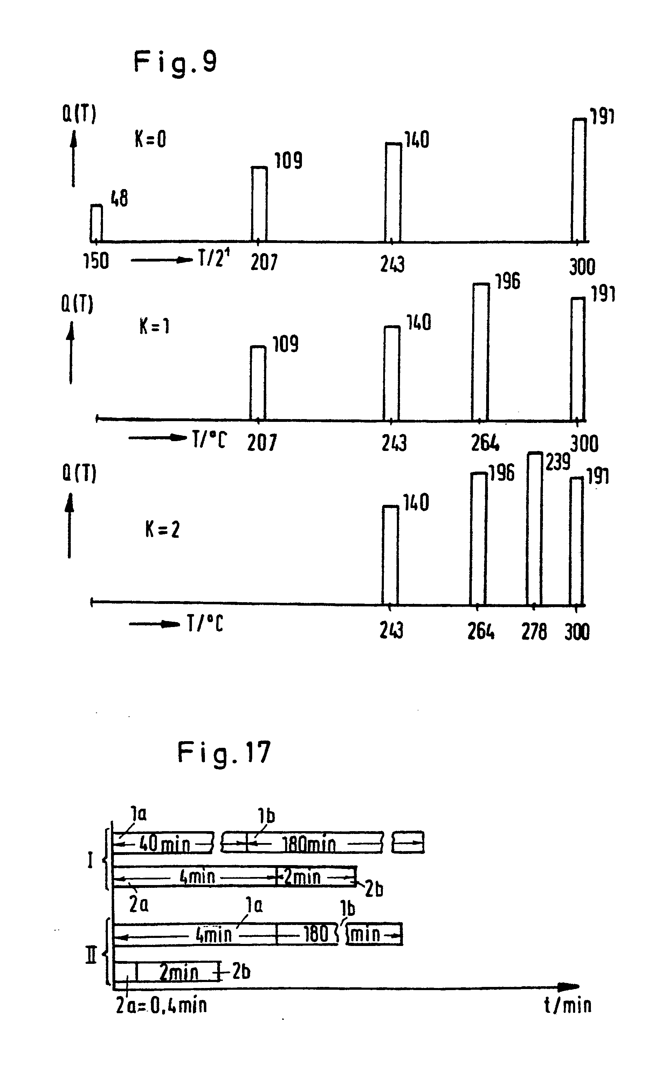

Die Fig. 9 veranschaulicht die eingeschlagene Strategie. Vorgegeben wurde ein Suchgebiet in den Temperaturgrenzen 150 °C und 300 °C. Aus der Literatur war bekannt, daß sich innerhalb dieses Intervalls die besten Schichtqualitäten erzeugen lassen. Die anderen Prozeßparameter:

Durchfluß V:         5 sccm (standard cubic centimeters per minute)
Druck p :           0,6 mbar = 0,6 hPa
HF-Leistung $P_{HF}$:   3 W

wurden konstant gehalten.

Das Suchgebiet wurde durch selbständig aufeinanderfolgende Suchschritte solange eingeengt, bis ein Optimum mit vorgegebenem Unsicherheitsintervall lokalisiert wurde. Im Startintervall K = O betrug die Mindestschrittweite $\Delta Tmin$ = 50 °C. Die Maßzahlen für die Qualität zeigen, daß auf jeden Fall Temperaturen unter 207 °C ausscheiden können. Im nächsten Schritt K = 1 wurde bei 264 °C eine Qualitätsmaßzahl von 196 ermittelt. Hieraus konnte zunächst der Rückschluß gezogen werden, daß unterhalb 264 °C geringere Qualitäten liegen, also auch unterhalb 243 °C keine höhere Qualität als bei 264 °C zu erwarten war. Weiter war nunmehr festzustellen, ob höhere Qualitäten als 196 oberhalb oder unterhalb von 264 °C auftreten. Im Schritt K = 2 wurde bei 278 °C die Qualitätsmaßzahl 239, das Maximum aller bisherigen Messungen, ermittelt. Die Suchintervall-Einengung wurde vom Rechner hier abgebrochen und die Temperatur 278 °C als Optimum akzeptiert, da das vorgegebene Unsicherheitsintervall unterschritten wurde.

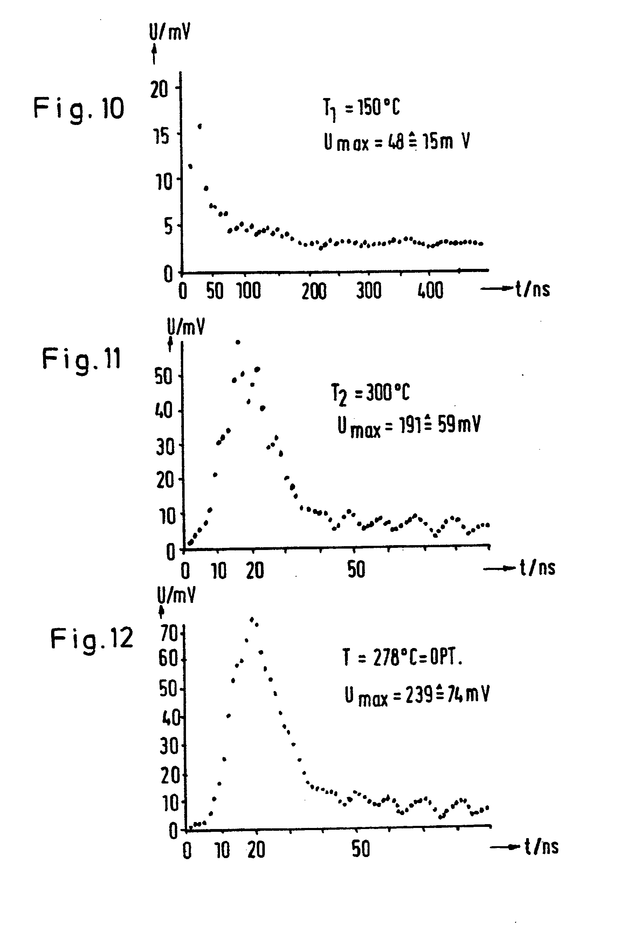

In den Fig. 10, 11 und 12 sind die in den Suchschritten K = 0 und 2 gemäß Fig. 9 gemessenen Qualitäten, als Photospannung über der Zeit bei den Temperaturen $T_1$ = 150 °C (Fig. 9), $T_2$ = 300 °C (Fig. 10) und $T_{opt}$ = 278 °C (Fig. 11) dargestellt. Die oben als Maßzahlenfür die Qualität angegebenen Werte sind Skalenteile und entsprechen bestimmten Spannungswerten, auf deren genaue Kenntnis bei der Optimierung jedoch verzichtet werden kann. Für diesen Zweck reichen die Angaben in Skalenteilen dem Rechner völlig aus. Der Arbeitsablauf über "CAPO" ergibt also nach drei Zyklen und sechs Qualitätsmessungen ein Optimum.

Auch für photoelektrochemische Vorgänge ist eine zeitaufgelöste Mikrowellenleitfähigkeitsmessung (time-resolved microwave conductivity = TRMC) von besonderer Bedeutung. Die Erzeugung von Ladungsträgern und deren Transport, die Änderung der Leitfähigkeit des flüssigen, photosensiblen Mediums, folgen auch hier einer Bestrahlung mit Lichtpulsen und werden mittels Mikrowellenabsorption bestimmt. Von Interesse dabei sind die Vorgänge an der Grenzschicht zwischen einem Halbleiter und einer Elektrolytflüssigkeit. Dementsprechend besteht die Leitfähigkeitsänderung aus zwei Anteilen, nämlich der induzierten Leitfähigkeit freier Ionen und elektrischer Ladungsträger sowie der Leitfähigkeit infolge einer Absorption elektrischer Energie von induzierten Dipolen. Hierüber wurde inzwischen auch in "J. Electrochem. Soc." Vol. 131, No. 4, April 1984, Seiten 954 bis 956, Verfasser: Kunst, M.; Beck, G.; Tributsch, H., berichtet.

Die technische Lehre der Erfindung ist also auch für die Herstellung von photoelektrochemischen Solarzellen und nicht nur für photoaktive Materialien und Festkörpersysteme anwendbar.

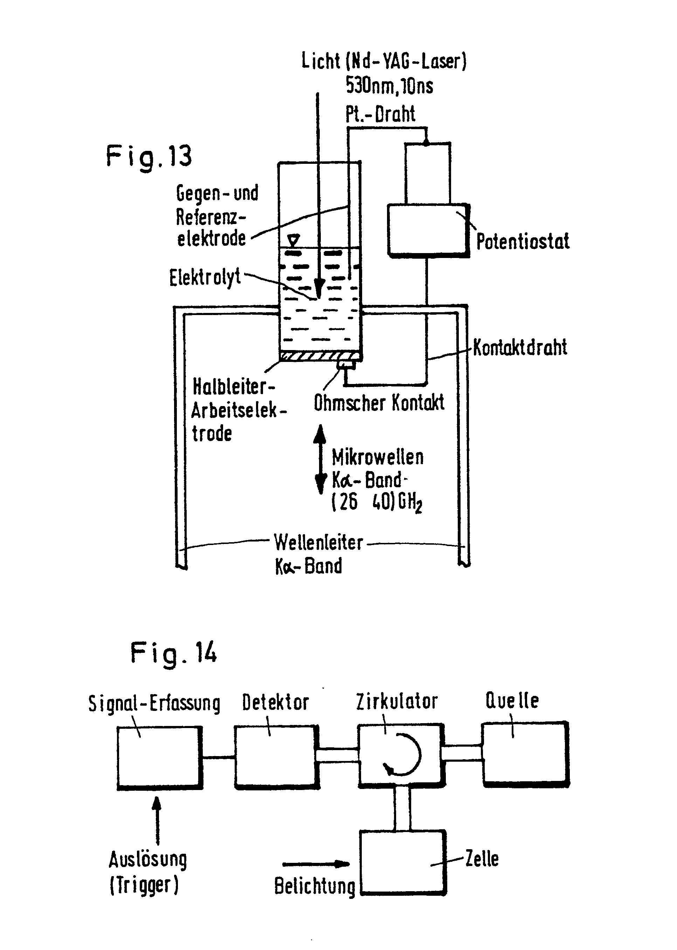

Die Fig. 13 zeigt hierzu einen Aufbau mit einer elektrochemischen Zelle, die aus einem Plastikrohr besteht und in das Zentrum eines kurzgeschlossenen Hohlleiters eingeschraubt ist. An der Unterseite des Plastikrohres befindet sich als Zellenboden eine Halbleiter-Arbeitselektrode. Als Gegenelektrode dient ein Platindraht. Die Elektrolytflüssigkeit wird von einer $K_2SO_4$-Lösung gebildet.

Entsprechend Fig. 14 werden Mikrowellen im Bereich von 26 GHz bis 40 GHz, z.B. 30 GHz, im Hohlleitersystem auf eine Halbleiterelektrode in einer von außen bestrahlten Zelle gerichtet, die quer zur Richtung der Wellenausbreitung angeordnet ist. Die Mikrowellen, die von der Grenzschicht zwischen Halbleiter und Elektrolytflüssigkeit reflektiert werden, gelangen über einen Richtkoppler oder Zirkulator zum Detektor. Dessen Ausgangssignal ist proportional zur Änderung der Mikrowellenleistung, zumindest für geringe Leistungen, und wird als Funktion der Zeit nach Anregung registriert.

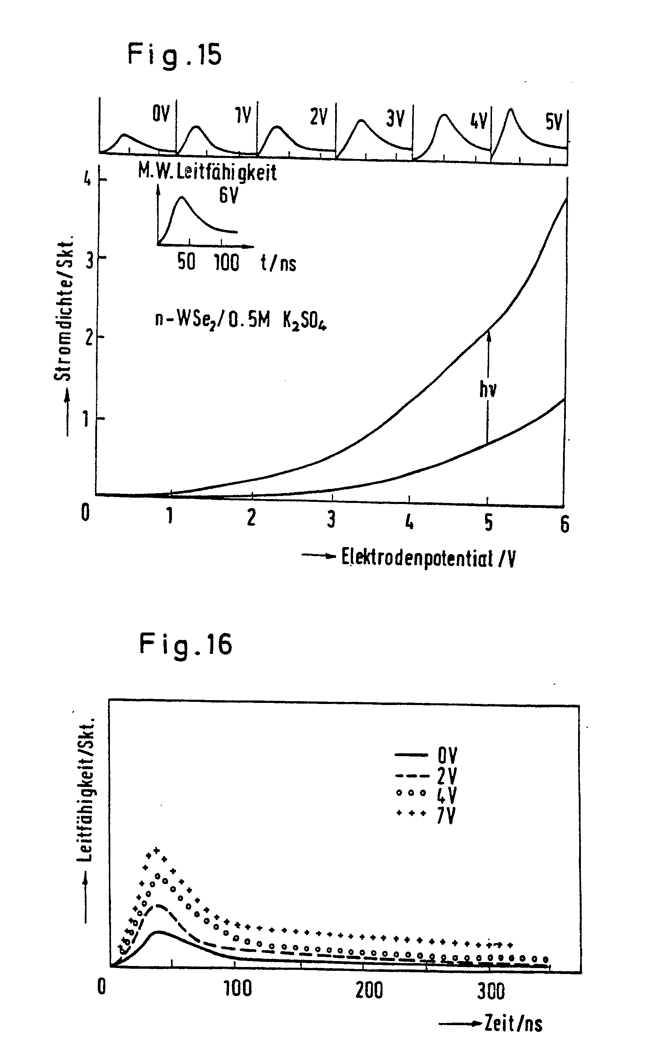

In den Fig. 15 und 16 sind solche Meßkurven dargestellt. Es zeigt sich, daß der Photostrom mit steigendem Elektrodenpotential, bis 6 V, immer stärker ansteigt, ohne in eine Sättigung zu gelangen. Die induzierte Leitfähigkeit zeigt zunächst einen schnell abfallenden Teil. (Die Abklingzeit wird teilweise vom Laserpuls bestimmt.) Danach nimmt die induzierte Leitfähigkeit langsamer ab.

Die in Fig. 17 dargestellten Zeitskalen sollen den Zeitgewinn veranschaulichen, der sich erzielen läßt, wenn statt bisher allgemein üblicher ex-situ Messungen nach dem erfindungsgemäßen Vorschlag gearbeitet wird. Dabei sind noch nicht solche Verkürzungen der Prozeßdauern berücksichtigt, die sich in erheblichem Umfang bei vollautomatischer Optimierung ergeben, also z.B. als höhere Ausbeute sowie als kürzere Aufeinanderfolge einzelner Arbeitsschritte bemerkbar machen. Der nach dem erfindungsgemäßen Verfahren erreichbare höhere Qualitätsstandard stellt einen weiteren Vorzug dar, der ebenfalls - wenn auch in anderer Beziehung - ins Gewicht fällt.

Typische Arbeitsschritte 1a, 1b bzw. 2a, 2b bestehen z.B. bei der Herstellung einer a-Si:H-Schicht aus folgenden Maßnahmen:

1 a: Abscheiderate für optimale Filmqualität
Monosilan - $SiH_4$: $r_d$ = 1...3 [Å/s] (1Å $\hat{=}$ $10^{-10}$m)
Disilan - $Si_2H_6$ : $r_d$ = 15...30 [Å/s]
Typische Schichtdicke: d = 5000 Å
1b: Abschalten der Anlage, Belüften, Probenentnahme,
Kontaktieren, Messen, Auswerten, neues Substrat
einführen, Ausgangszustand herstellen, neue
Schichtabscheidung starten.
2a: Abscheideraten wie bei 1a
Typische Schichtdicke: d = 500 Å
(Mindestschichtdicke zur Qualitätssignalerfassung)
2b: Belichten, Qualitätsbestimmung während der Glimmentladung, Meßsignal weiterleiten, rechnerinterne
Verarbeitung, Einstellung der Aktoren, neue Schichtabscheidung starten.

Die Qualitätsbestimmung bei 2b wird in situ z.B. als zeitaufgelöste Mikrowellenleitfähigkeit (TRMC) oder der Photoleitfähigkeit (PC) durchgeführt.

Die Zeilenpaare I und II in Fig. 17 beziehen sich auf durchschnittliche Abscheideraten von 2 Å/s bei I

EP 0 153 901 B1

bzw. 20Å/s bei II. Daraus folgt:

$$t(I.1a + 1b) = 220 \text{ min}; \quad \frac{t(I.1)}{t(I.2)} = \frac{36,7}{1}$$
$$t(I.2a + 2b) = 6 \text{ min};$$

$$t(II.1a + 1b) = 184 \text{ min}; \quad \frac{t(II.1)}{t(II.2)} = \frac{76,7}{1}$$
$$t(II.2a + 2b) = 2,4 \text{ min};$$

**Ansprüche**

1. Verfahren zur Herstellung von halbleitenden Materialien und/oder Halbleiter-Bauelementen, bei dem unter Verwendung einer Regelschleife, in der Meß- und Stellglieder über einen Rechner gekoppelt sind, in-situ eine Materialeigenschaft untersucht wird und aufgrund der Untersuchungsergebnisse die Parameter des Herstellungsprozesses eingestellt werden,
   **dadurch gekennzeichnet, daß**
   für Materialien und/oder Bauelemente, die im wesentlichen photoaktive Eigenschaften aufweisen, eine Optimierung der Herstellung bezüglich Qualität, Ausbeute und Prozeßdauer herbeigeführt wird, indem:
   a) Schichten des Materials/Bauelements kontinuierlich, unter änderbaren Prozeßbedingungen ausgebildet werden;
   b) das Material/Bauelement während der Ausbildung von Schichten zum Detektieren der zu untersuchenden Materialeigenschaft einem elektromagnetischen Feld ausgesetzt wird;
   c) als zu untersuchende Materialeigenschaft die Photoleitfähigkeit verwendet wird, die durch Bestrahlen der sich ausbildenden Schichten infolge Anregung von Ladungsträgern herbeigeführt wird;
   d) Änderungen der Photoleitfähigkeit durch wiederholtes Bestrahlen hervorgerufen, detektiert und als Meßwerte erfaßt werden;
   e) erfaßte Meßwerte dem Rechner zugeführt und dort hinsichtlich des aktuell erreichbaren Optimums ausgewertet werden;
   f) Steuersignale für Stellglieder, mit denen die Prozeßbedingungen vorgegeben werden, vom Rechner bereitgestellt werden;
   g) die betreffenden Prozeßparameter den Steuersignalen entsprechend geändert werden;
   h) die unter c) bis g) angegebenen Maßnahmen mehrmals durchgeführt werden, während die unter a) und b) angegebenen Maßnahmenso lange aufrechterhalten bleiben, bis die optimal auszubildende Schicht vollständig entwickelt ist.

2. Verfahren nach Anspruch 1,
   **dadurch gekennzeichnet, daß**
   die Photoleitfähigkeit des Materials als Änderungen eines Mikrowellenfeldes kontaktlos gemessen wird.

3. Verfahren nach Anspruch 1,
   **dadurch gekennzeichnet, daß**
   Änderungen der Photoleitfähigkeit direkt über Kontakte gemessen werden.

4. Verfahren nach einem der Ansprüche 1 bis 3,
   **dadurch gekennzeichnet, daß**
   die Anregung von Ladungsträgern im photoaktiven Material durch Elektronenbestrahlung herbeigeführt wird.

5. Verfahren nach einem der Ansprüche 1 bis 3,
   **dadurch gekennzeichnet, daß**
   die Anregung von Ladungsträgern im photoaktiven Material durch Bestrahlung mit Lichtwellen herbeigeführt wird.

8

6. Verfahren nach Anspruch 5,
   **dadurch gekennzeichnet, daß**
   die Anregung mit weißem Licht erfolgt.

7. Verfahren nach Anspruch 5,
   **dadurch gekennzeichnet, daß**
   die Anregung mit monochromatischem Licht erfolgt.

8. Verfahren nach einem der Ansprüche 1 bis 7,
   **dadurch gekennzeichnet, daß**
   alle Arbeitsschritte in nur einer Prozeßkammer durchgeführt werden.

9. Verfahren nach einem der Ansprüche 1 bis 7,
   **dadurch gekennzeichnet, daß**
   einzelne Verfahrensstufen in separaten Prozeßkammern durchgeführt werden.

10. Verfahren nach Anspruch 9,
    **dadurch gekennzeichnet, daß**
    das Material bzw. Bauelement im Verlauf der Herstellung quasi-kontinuierlich von einer Prozeßkammer zur nächsten transportiert wird.


**Claims**

1. Method for producing semiconducting materials and/or semiconductor components, by which with use of a closed loop, in which measuring and adjusting elements are coupled by way of a computer, a material property is investigated in-situ and by virtue of the results of the investigation the parameters of the production process are adjusted, characterised in that optimization of the production with regard to quality, yield and process duration is brought about for materials and/or components which have substantially photoactive properties, in that:
   a) layers of the material/component are continuously formed under variable process conditions;
   b) the material/component is exposed to an electromagnetic field during the formation of layers for the purpose of detecting the material property to be investigated;
   c) the photoconductivity, which is owing to excitation of charge carriers induced by irradiation of the layers being formed, is used as the material property to be investigated;
   d) changes in the photoconductivity are brought about by repeated irradiation, detected and recorded as measured values;
   e) recorded measured values are fed to the computer and there evaluated with regard to the optimum which can currently be attained;
   f) control signals for adjusting elements, with which the process conditions are preset, are made available by the computer;
   g) the relevant process parameters are changed in accordance with the control signals;
   h) the measures specified under c) to g) are carried out several times, whilst the measures specified under a) and b) are maintained for so long until the layer to be formed in the optimum manner has developed completely.

2. Method according to claim 1, characterised in that the photoconductivity of the material is measured in a contactless manner as changes in a microwave field.

3. Method according to claim 1, characterised in that changes in the photoconductivity are measured directly by way of contacts.

4. Method according to one of the claims 1 to 3, characterised in that the excitation of charge carriers in the photoactive material is brought about by electron irradiation.

5. Method according to one of the claims 1 to 3, characterised in that the excitation of charge carriers in the photoactive material is brought about by irradiation with light waves.

6. Method according to claim 5, characterised in that the excitation occurs with white light.

7. Method according to claim 5, characterised in that the excitation occurs with monochromatic light.

8. Method according to one of the claims 1 to 7, characterised in that all the working steps are carried out in just one process chamber.

9. Method according to one of the claims 1 to 7, characterised in that individual method steps are carried out in separate process chambers.

10. Method according to claim 9, characterised in that the material or component is transported in the course of production quasi-continuously from one process chamber to the next.

## Revendications

1. Procédé de fabrication de matériaux semi-conducteurs et/ou de dispositifs à semi-conducteur, dans lequel une propriété de matériau est examinée in situ par l'utilisation d'une boucle de régulation dans laquelle des éléments de mesure et de réglage sont connectés par l'intermédiaire d'un calculateur et dans lequel les paramètres du procédé de fabrication sont réglés sur base des résultats de mesure, caractérisé en ce que pour des matériaux et/ou dispositifs, qui présentent essentiellement des propriétés photoactives, une optimisation de la fabrication est opérée en ce qui concerne la qualité, le rendement et la durée du processus, pendant que :
   a) des couches du matériau/dispositif sont formées de façon continue sous des conditions de processus variables;
   b) le matériau/dispositif est exposé à un champ électromagnétique durant la formation de couches afin de détecter les propriétés du matériau à examiner;
   c) la photoconductibilité est utilisée comme propriété de matériau à examiner, laquelle photoconductibilité est provoquée par irradiation des couches en formation suite à une activation de porteurs de charge;
   d) des variations de la photoconductibilité sont suscitées par irradiation répétée, détectées et saisies sous forme de valeurs de mesure;
   e) les valeurs de mesure obtenues sont appliquées à un calculateur et y sont exploitées en ce qui concerne l'optimum accessible actuel;
   f) des signaux de commande pour des éléments de réglage au moyen desquels sont prédéfinies les conditions du procédé, se trouvent produits par le calculateur;
   g) les paramètres correspondants du procédé sont modifiés d'après les signaux de commande;
   h) les étapes c) à g) sont effectuées plusieurs fois tandis que les étapes a) et b) sont poursuivies jusqu'à ce que la couche à former de manière optimale soit complètement développée.

2. Procédé selon la revendication 1, caractérisé en ce que la photoconductibilité du matériau est mesurée sans contact comme variations d'un champ micro-onde.

3. Procédé selon la revendication 1, caractérisé en ce que les variations de la photoconductibilité sont mesurées directement au moyen de contacts.

4. Procédé selon l'une des revendications 1 à 3, caractérisé en ce que l'activation de porteurs de charge dans le matériau photoactif est provoquée par irradiation électronique.

5. Procédé selon l'une des revendications 1 à 3, caractérisé en ce que l'activation de porteurs de charge dans le matériau photoactif est provoquée par irradiation au moyen d'ondes lumineuses.

6. Procédé selon la revendication 5, caractérisé en ce que l'activation est produite avec de la lumière blanche.

7. Procédé selon la revendication 5, caractérisé en ce que l'activation est produite avec de la lumière monochromatique.

8. Procédé selon l'une des revendications 1 à 7, caractérisé en ce que tous les stades de travail sont effectués dans une seule chambre d'opération.

9. Procédé selon l'une des revendications 1 à 7, caractérisé en ce que des étapes particulières du procédé sont effectuées dans des chambres d'opération séparées.

10. Procédé selon la revendication 9, caractérisé en ce que le matériau ou le dispositif est transporté de manière quasi continue d'une chambre d'opération à la suivante pendant la fabrication.

## Fig.1

## Fig.4

MONOMER

hν

P

MIKROWELLEN

POLYMER

KATALYSATOR

KUNSTSTOFFOLIE

SUBSTRATTRÄGER
(z.B. GLAS)

# Fig. 2

START

Prozeß an

Einstellen der Aktoren
nach den Parameterwerten

Variablenwerte für Prozeßparameter
erzeugen durch eine Opt.-Strategie

Informationsaufnahme
der Sensorsignale im
Rechner

Beschichten des
Substratträgers

Leitfähigkeitsmessung
(TRMC, PC) als Referenz
zu Beginn eines neuen
Arbeitszyklus, z.B.
nach längerer Pause
oder nach n
Optimierungsschritten

Belichten plus Leitfähigkeitsmessung

Signalerfassung und
- auswertung

η

Anzahl der Messungen i (i = 1,2...n) =
Anzahl der Messungen n
pro Optimierungsschritt bzw. -gene-
ration

Auswahl der Parameterwertekombination
derjenigen Schicht
mit dem besten
Qualitätssignal

γ

η

Unterschied zwischen den Qualitätssignalen der Optimierungsschritte bzw.
-generationen ≦ Abbruchkriterium ε

γ

STOP

EP 0 153 901 B1

Fig.3

14

## Fig.5

HF-Generator

Gegenelektrode

Laserpuls

Prozeßkammer P
(Plasma-Deposition)

Silan

aSi:H

Meßkontakt

Meßkontakt

Substrat
(Quarz)

Trägerelektrode

Thermoelement

Heizleiter

Digitalisierer

$50\,\Omega$

U
$(0....1)\mathrm{kV}$

Rechner R

an Aktoren

## Fig.6

HF-Generator

Gegenelektrode

Laserpuls

Prozeßkammer P
(Plasma-Deposition)

Silan

aSi:H

Substrat
(Quarz)

Trägerelektrode

Heizleiter

Thermoleiter

Hohlleiter

Mikrowellen-
quelle

Zirkulator

Detektor

Digitalisierer

Rechner R

an Aktoren

Fig.7

Fig.8

Fig.9

Fig.17

Fig. 10

$T_1 = 150°C$

$U_{max} = 48 \triangleq 15\,mV$

Fig. 11

$T_2 = 300°C$

$U_{max} = 191 \triangleq 59\,mV$

Fig. 12

$T = 278°C = OPT.$

$U_{max} = 239 \triangleq 74\,mV$

18

Fig.13

Licht (Nd-YAG-Laser)
530nm, 10ns
Pt.-Draht

Gegen- und Referenz- elektrode

Elektrolyt

Potentiostat

Kontaktdraht

Halbleiter- Arbeitselek- trode

Ohmscher Kontakt

Mikrowellen Ka-Band- (26 40)GH$_2$

Wellenleiter Ka-Band

Fig.14

Signal-Erfassung   Detektor   Zirkulator   Quelle

Auslösung (Trigger)

Belichtung

Zelle

## Fig.15

M.W.Leitfähigkeit

n-WSe$_2$/0.5M K$_2$SO$_4$

## Fig.16